# EUROPEAN PATENT APPLICATION

(11) **EP 2 045 318 A1**
(43) Date of publication of application: **08.04.2009**
(21) Application number: 08016206.8
(22) Date of filing: 15.09.2008
(51) Int. Cl.: C11D 11/00, C11D 3/28, C11D 7/32, C11D 3/20, C11D 7/26, H01L 21/02, G03F 7/42

(54) **Cleaning agent for semiconductor device and cleaning method using the same**

(30) Priority: 28.09.2007 JP 2007255968
(71) Applicant: FUJIFILM Corporation, Minato-ku Tokyo (JP)
(72) Inventor: Nishiwaki, Yoshinori, Haibara-gun Shizuoka-ken (JP)
(74) Representative: HOFFMANN EITLE

(57) **Abstract**

The present invention provides a cleaning agent for cleaning a semiconductor device having copper wiring on the surface thereof following a chemical mechanical polishing process in a production process of a semiconductor device, including a compound represented by the following formula (I):

X¹-L-X² formula (I)

wherein, in formula (I), X¹ and X² each independently represent a monovalent substituent formed by removing one hydrogen atom from a heterocycle containing at least one nitrogen atom, and L represents a divalent linking group; and provides a cleaning method using the cleaning agent.

## Description

### BACKGROUND OF THE INVENTION

### Field of the Invention

The present invention relates to a cleaning agent used in cleaning a semiconductor device after a process of planarization by chemical mechanical polishing (hereinafter, referred to as "CMP") in a process for producing a semiconductor device, and a cleaning method using the same.

### Description of the Related Art

In production of semiconductor devices typified by semiconductor integrated circuits (hereinafter, referred to as "LSIs"), a multilayer laminated structure having a substrate laminated with plural layers such as an insulating layer and a metal layer is formed. In multilayer lamination, an ordinary interlayer dielectric such as a p-TEOS film or an O₃-TEOS film as well as an interlayer dielectric film (ILD films) including an interlayer film having a low dielectric constant of about 3.5 to 2.0 (for example, an organic polymer based film, a methyl group containing silica based film, a H-Si containing silica based film, a SiOF based film, a porous silica based film, and a porous organic material based film, which are usually referred to as low-k films), and metal films of copper used in wiring are deposited on the substrate. Then, the resulting unevenness due to the deposition process is planarized by carrying out a planarizing treatment by CMP, and new wiring is laminated on the planarized surface. In recent years, along with progress in reducing the width of lines of semiconductor devices, planarity at high accuracy has becoming more and more necessary in each of the layers of the substrate.

Accordingly, the expectations of a CMP process are high, and a planarizing process by CMP is becoming popular in production processes for semiconductor devices, and the subsequent cleaning process is also playing an important role.

Conventionally, an acidic cleaning agent (hydrochloric acid, hydrofluoric acid or the like) which is usually used as a cleaning agent for semiconductors has been used in a washing step after a Cu-CMP step aimed at planarization after formation of copper wiring, but this cleaning agent is not preferable on concern that it may dissolve not only copper oxide adhering to the insulating film but also metal copper in the wiring to corrode or break the wiring. For removing particles adhering to, and remaining on, the surface of a semiconductor device after the polishing step, an alkaline cleaning agent causing the surface of the semiconductor and the particles repel to each other is considered generally useful, and for example, a cleaning agent containing a specific surfactant and an alkali or an organic acid (see, for example, Japanese Patent Application Laid-Open (JP-A) No. 2003-289060) and a cleaning agent to which an organic acid, an organic alkali and a surfactant are added (see, for example, JP-A No. 2005-260213) have been proposed. However, these cleaning agents were not perfect from the viewpoint of efficient removal of metal or substrate material derived from materials to be polished adhering on the surface of the substrate, and residues of organic matters or abrasive particles.

When a metal ion-containing cleaning agent such as sodium hydroxide or potassium hydroxide is used as alkali source as a substitute for an organic alkali, its metal may be adsorbed on the surface of an insulating film (silicon oxide) to deteriorate insulating characteristics. Among alkaline cleaning agents, a cleaning agent containing a metal ion-free inorganic alkali (ammonia water or the like) has strong power to dissolve copper and is thus hardly usable for these purposes.

On the other hand, a cleaning agent containing quaternary ammonium is advantageous in that it has a significant effect of removing particles without corroding copper wiring, but the quaternary ammonium is so strongly alkaline that it has a strong etching power on an insulating layer, and thus suffers from a disadvantage of roughening its surface that was planarized by CMP process. To overcome this disadvantage, it is known that the etching speed may be decreased by adding hydrogen peroxide to quaternary ammonium. In this case, however, there arises a problem that by the oxidizing power of hydrogen peroxide, the surface of copper wiring is oxidized to deteriorate conductive property.

As described above, there is demand at present for a cleaning agent capable of effectively removing impurities on the surface of a semiconductor device provided with copper wiring, without causing corrosion or oxidation of the copper wiring and without roughening the planarized surface.

The object of the present invention made in consideration of the problem described above is a cleaning agent used in a washing step after a planarizing/polishing step in a process for producing a semiconductor device, which may effectively remove impurities on the surface of a semiconductor device, particularly a semiconductor device provided thereon with copper wiring, without causing corrosion or oxidation of copper wiring and without causing deterioration in the surface condition of a planarized device, as well as a cleaning method using the same.

The present invention has been made in view of the above circumstances and provides a cleaning agent for semiconductor devices and a cleaning method using the same. The inventors intensively have examined the problem of the cleaning agent used after the CMP process, and as a result they found that the problem may be solved by using a cleaning agent constituted as shown below, and the invention was thereby completed.

### SUMMARY OF THE INVENTION

A first aspect of the invention provides:
<1> A cleaning agent for cleaning a semiconductor device having copper wiring on the surface thereof after a chemical mechanical polishing process in a production process of the semiconductor device, the cleaning agent comprising a compound represented by the following formula (I):

   X¹-L-X² formula (I)
wherein, in formula (I), X¹ and X² each independently represent a monovalent substituent formed by removing one hydrogen atom from a heterocycle containing at least one nitrogen atom, and L represents a divalent linking group.

A second aspect of the invention provides a method of cleaning a semiconductor device provided with copper wiring thereon, which comprises using the cleaning agent of the first aspect of the invention.

### DETAILED DESCRIPTION OF THE INVENTION

The mechanism of the present invention is not clear, but it is thought to be as follows: The compound represented by the formula (I) used in the cleaning agent, by virtue of its structure, that is, a heterocyclic structure contained in the molecule thereof, has high power to capture residues of organic matters such as a passivation film remaining on the surface of a substrate, thus substituting or adsorbing organic matters remaining on the surface of a substrate after CMP process, thereby removing the organic matters from the surface and effectively dissolving and dispersing them in the cleaning solution. This function possessed by the compound represented by the formula (I) is attributable to a mechanism different from that of the organic matter-dissolving action of an acid or alkali that exerts an influence on the surface of a substrate, thus enabling removal of residues of organic matters without giving damage to the surface of a substrate, particularly the surface of metal wiring such as copper wiring formed on the surface of a substrate.

The semiconductor device that is the object of cleaning with the cleaning agent of the invention is a substrate that has been subjected to chemical mechanical polishing in a process for production of a semiconductor device, and the substrate may be either a single-layer substrate having metal wiring formed on the surface of a substrate material or a multilayered wiring board having wiring formed via an interlayer dielectric on the surface thereof.

According to the invention, there may be provided a cleaning agent used in a washing step after a planarizing/polishing step in a process for producing a semiconductor device, which may effectively remove impurities on the surface of a semiconductor device, particularly a semiconductor device provided thereon with copper wiring, without causing corrosion or oxidation of copper wiring and without causing deterioration in the surface condition of a planarized device, as well as a cleaning method using the same.

Specific aspects of the invention will be described below.

The cleaning agent of the invention is a cleaning agent for cleaning a semiconductor device having copper wiring on the surface thereof after a chemical mechanical polishing process in a process for production of a semiconductor device, including a compound represented by the following formula (I):

X¹-L-X² formula (I)

wherein X¹ and X² each independently represent a monovalent substituent formed by removing one hydrogen atom from a heterocycle containing at least one nitrogen atom, and L represents a divalent linking group.

First, the compound represented by the formula (I), that is, a characteristic component contained in the cleaning agent of the invention is described.

### <(A) Compound represented by formula (I)>

X¹-L-X² formula (I)

wherein X¹ and X² each independently represent a monovalent substituent formed by removing one hydrogen atom from a heterocycle containing at least one nitrogen atom.

The monovalent substituent represented by X¹ and X² is a substituent derived from a heterocyclic structure, that is, a substituent derived from a heterocycle by removing one hydrogen atom from its ring structure.

The heterocycle that may constitute the monovalent substituent is not particularly limited as long as it is a heterocycle having a nitrogen atom(s) in its molecule, and the number of nitrogen atoms contained in the heterocycle is preferably 1 to 5, more preferably 2 to 4, most preferably 3 or 4. Its ring structure may be either a monocyclic structure composed of 5 rings or a monocyclic structure selected from 3-, 4-, 5-, 6- and 7-memberred rings or may be a ring-fused structure thereof, but is preferably a 5- or 6-memberred ring.

Specific examples of a nitrogen-containing heterocycle that may constitute the monovalent substituent represented by X¹ and X² in the formula (I) include a pyrrole ring, a pyran ring, an imidazole ring, a pyrazole ring, a thiazole ring, an isothiazole ring, an oxazole ring, an isooxazole ring, a pyridine ring, a pyrazine ring, a pyrimidine ring, a pyridazine ring, a pyrrolidine ring, a pyrazolidine ring, an imidazolidine ring, an isoxazolidine ring, an isothiazolidine ring, a piperidine ring, a piperazine ring, a morpholine ring, a thiomorpholine ring, an indoline ring, an isoindoline ring, an indolizine ring, an indole ring, an indazole ring, a purine ring, a quinolizine ring, an isoquinoline ring, a quinoline ring, a naphthyridine ring, a phthalazine ring, a quinoxaline ring, a quinazoline ring, a cinnoline ring, a pteridine ring, an acridine ring, a perimidine ring, a phenanthroline ring, a carbazole ring, a carboline ring, a phenazine ring, an anthyridine ring, a thiadiazole ring, an oxadiazole ring, a triazine ring, a 1,2,3-triazole ring, a 1,2,4-triazole ring, a tetrazole ring, a benzimidazole ring, a banzoxazole ring, a benzothiazole ring, a benzothiadiazole ring, a benzofuroxan ring, a naphthoimidazole ring, a benzotriazole ring and a tetraazaindene ring, and a monovalent substituent derived from a heterocycle selected from these rings is preferable.

Preferable among them are a tetrazole ring, a 1,2,4-triazole ring, a 1,2,3-triazole ring and a benzotriazole triazole ring, among which a triazole ring and a 1,2,3-triazole ring are more preferable.

X¹ and X² may be the same or different from each other, but are preferably the same from the viewpoint of synthesis suitability.

The divalent linking group represented by L in the formula (I) is preferably an alkylene group (for example, a methylene group, an ethylene group, a trimethylene group, a tetramethylene group, a hexamethylene group, a 1,4-cyclohexylene group, or a 1,1,3-trimethylhexylene group), an arylene group (for example, a p-phenylene group, an m-phenylene group, or a naphthalene group), a heterocyclic group (for example, a pyridine ring-linking group, a triazine ring-linking group, a triazole ring-linking group, or a thiadiazole ring-linking group), an ureido group, an amide group, an ester group, a carbonate group, a carbamate group, a sulfonamide group, a thioureido group, an ether group, a thioether group and an amino group, or a linking group constituted by combination of two or more thereof.

The linking group represented by L is preferably a group constituted by containing a group selected from an ureido group, a thioureido group, an amide group, an ester group, a carbonate group, a carbamate group, a sulfonamide group, a sulfonureido group, a hydroxy group, an ether group, a thioether group, an amino group, a carboxy group, a sulfo group and a heterocyclic group.

From the viewpoint of corrosion prevention performance and synthesis suitability, the distance between the heterocyclic structural rings represented by X¹ and X² is 3 to 15 in terms of the number of atoms used in connection between the 2 substituents represented by X¹ and X².

The linking group L in the formula (I) may further substituents wherever possible, and the substituent that may be introduced into L includes a halogen atom (a fluorine atom, a chlorine atom, a bromine atom or an iodine atom), an alkyl group (a linear, branched or cyclic alkyl group; the group may be a polycyclic alkyl group such as a bicyclo-alkyl group or may include an active methine group), an alkenyl group, an alkynyl group, an aryl group, a heterocyclic group (its substituted site is not restricted), an acyl group, an alkoxycarbonyl group, an aryloxycarbonyl group, a heterocyclic oxycarbonyl group, a carbamoyl group (examples of the carbamoyl group having substituents include an N-hydroxycarbamoyl group, an N-acylcarbamoyl group, an N-sulfonylcarbamoyl group, an N-carbamoylcarbamoyl group, a thiocarbamoyl group and an N-sulfamoylcarbamoyl group), a carbazoyl group, a carboxyl group or salts thereof, an oxalyl group, an oxamoyl group, a cyano group, a carbonimidoyl group, a formyl group, a hydroxy group, an alkoxy group (including groups having repeated ethyleneoxy or propyleneoxy groups), an aryloxy group, a heterocyclic oxy group, an acyloxy group, an (alkoxy or aryloxy) carbonyloxy group, a carbamoyloxy group, a sulfonyloxy group, an amino group, an (alkyl, aryl or heterocyclic) amino group, an acylamino group, a sulfonamide group, an ureido group, a thioureido group, an N-hydroxyureido group, an imido group, an (alkoxy or aryloxy) carbonylamino group, a sulfamoylamino group, a semicarbazide group, a thiosemicarbazide group, a hydrazino group, an ammonio group, an oxamoylamino group, an N-(alkyl or aryl) sulfonylureido group, an N-acyl ureido group, an N-acyl sulfamoylamino group, a hydroxyamino group, a nitro group, a heterocyclic rings containing quaternarized nitrogen atoms (for example, a pyridinio group, an imodazolio group, a quiolinio group or an isoquinolinio group), an isocyano group, an imino group, a mercapto group, an (alkyl, aryl or heterocyclic) thio group, an (alkyl, aryl or heterocyclic) dithio group, an (alkyl or aryl) sulfonyl group, an (alkyl or aryl) sulfinyl group, a sulfo group, a sulfamoyl group (examples of the sulfamoyl group having substituents include an N-acylsulfamoyl group and an N-sulfonylsulfamoyl group), a phosphino group, a phosphinyl group, a phosphinyloxy group, a phosphinylamino group, and a silyl group.

Examples of the divalent linking group represented by L in the formula (I) include linking groups (Exemplary Linking Groups (L-1) to (L-16)) shown below:

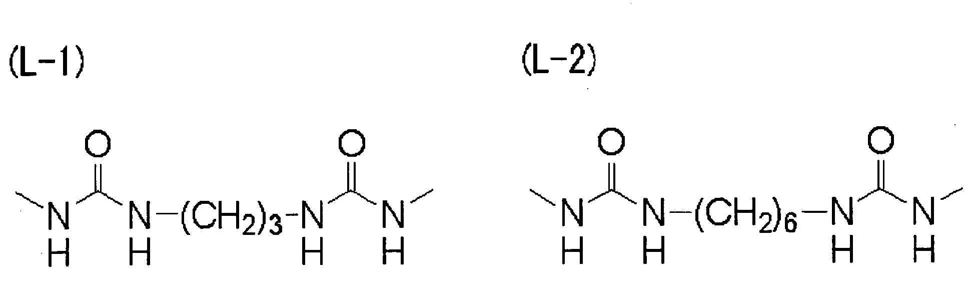

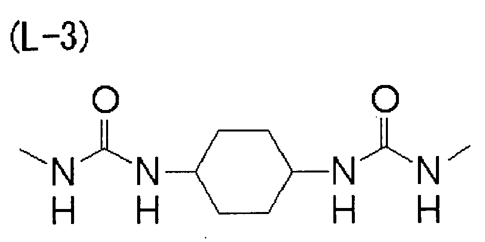

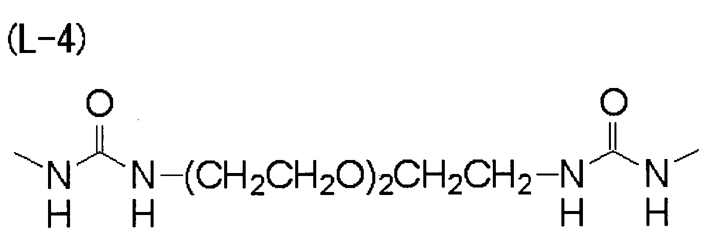

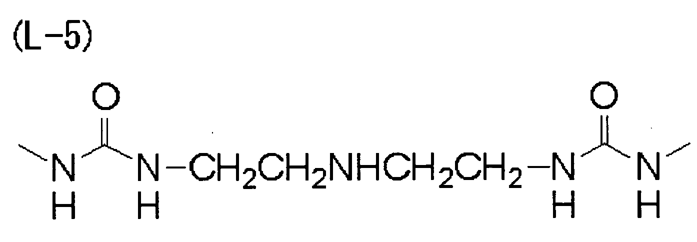

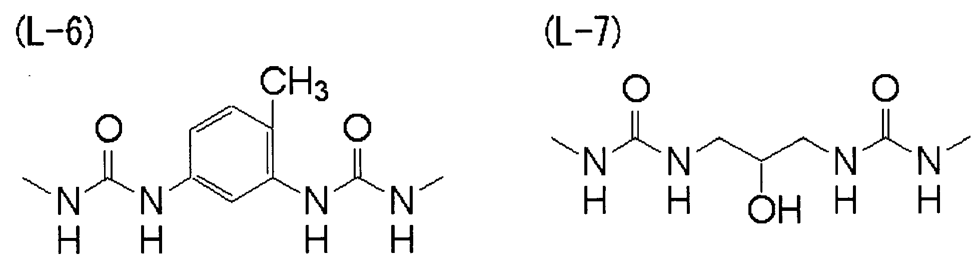

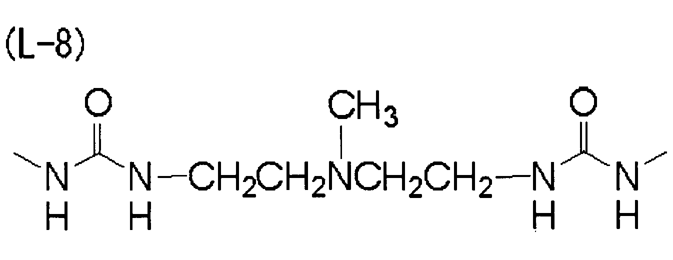

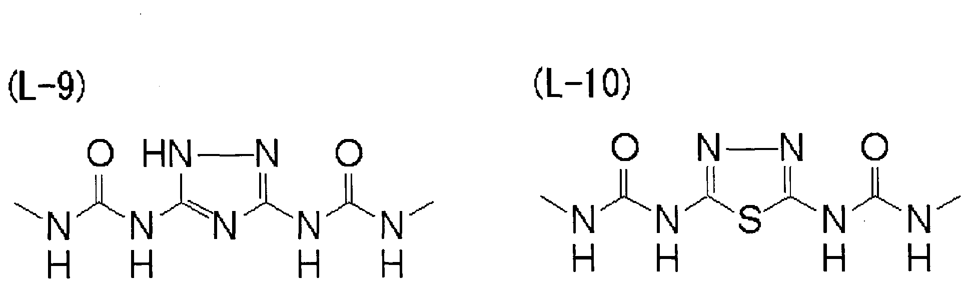

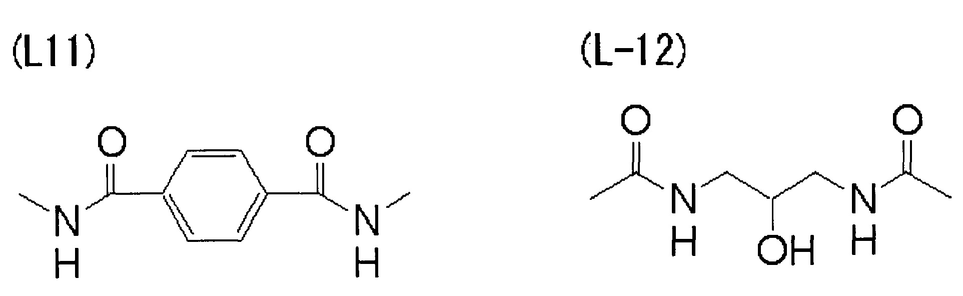

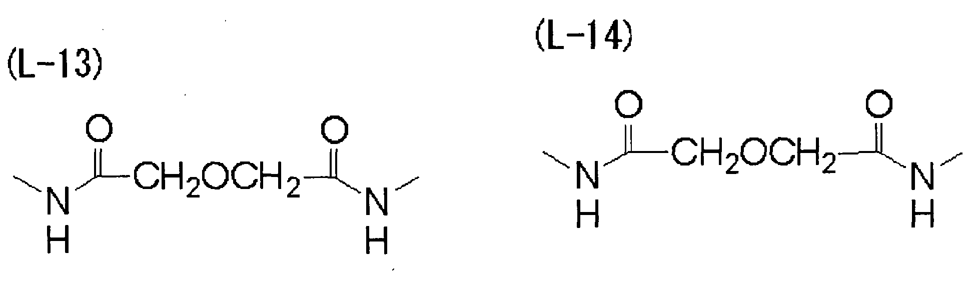

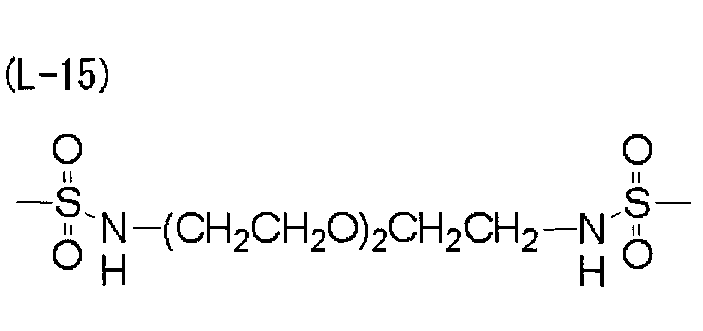

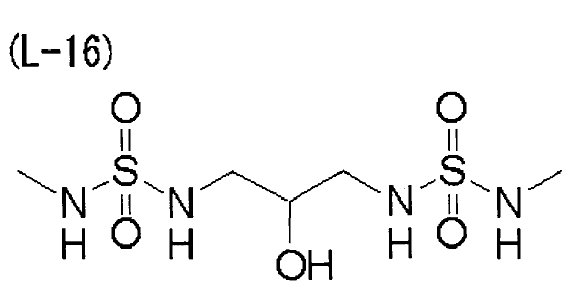

The divalent linking group represented by L in the formula (I) is preferably either a linking group constituted by containing an ureido group, an amide group, an ester group, a carbonate group, a carbamate group, a sulfonamide group, a hydroxy group, an ether group, a thioether group, an amino group, a carboxy group, a sulfo group and a heterocyclic group, or a divalent linking group containing a substituent such as a hydroxy group, a carboxy group or a sulfo group.

By introducing, as substituents on the linking group L, heterocycle structure-derived substituents such as the monovalent substituents represented by X¹ and X², the compound may have a structure containing 3 or more of such heterocycle ring-derived monovalent substituents in one molecule.

The divalent linking group represented by L in the formula (I) is preferably a linking group constituted by containing an ureido group, an amide group, an ether group, or an amino group, and a linking group having a hydroxy group as a substituent.

Specific examples (Exemplary Compounds (I-1) to (I-44)) represented by the formula (I) in the invention are shown below, but the invention is not limited thereto.

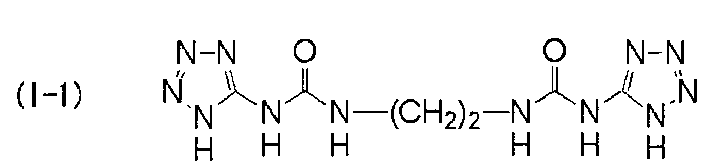

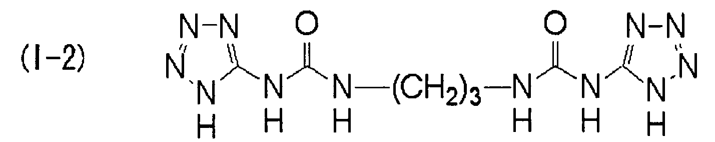

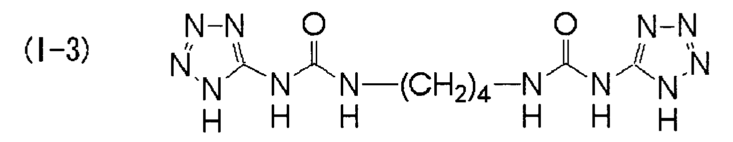

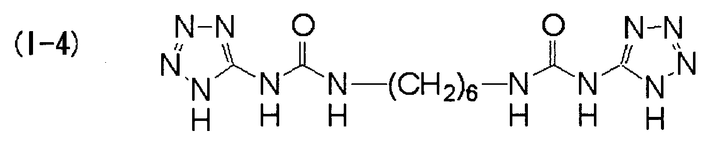

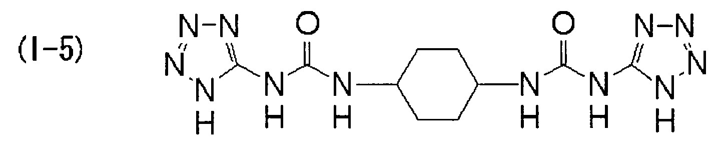

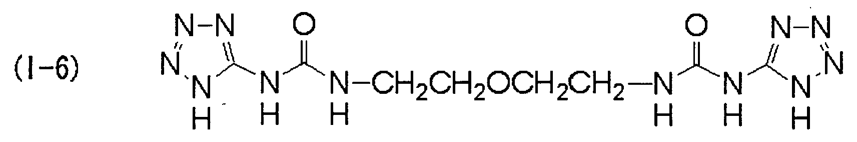

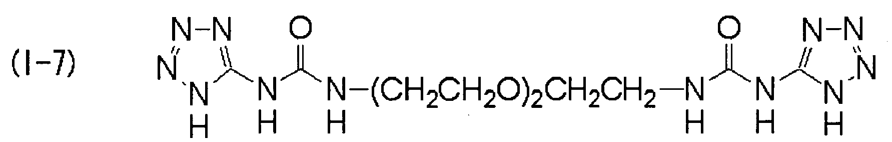

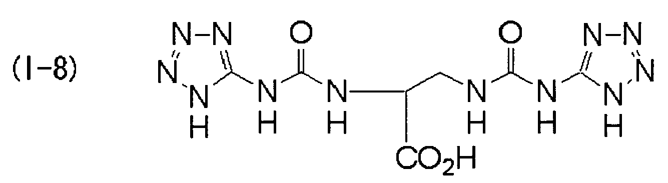

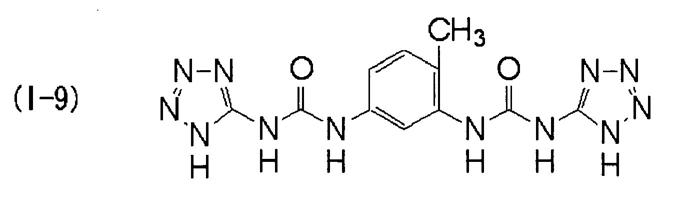

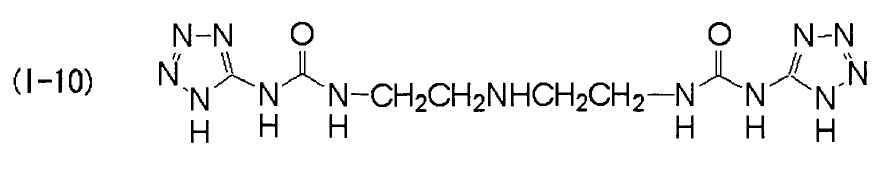

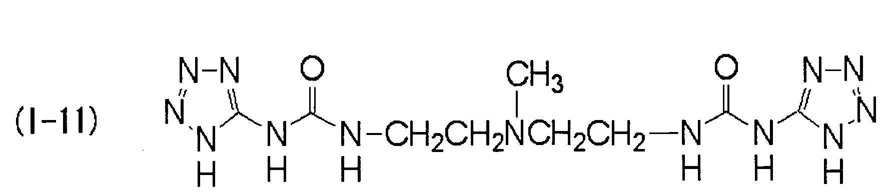

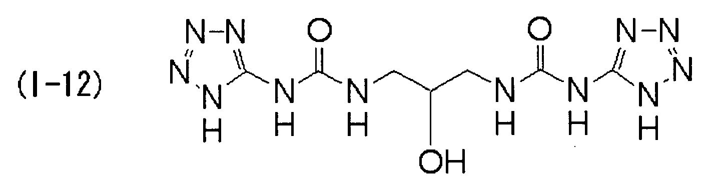

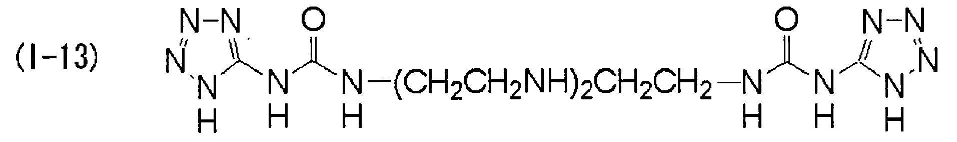

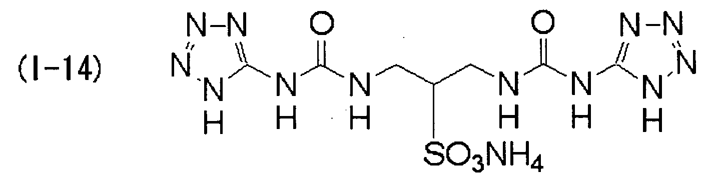

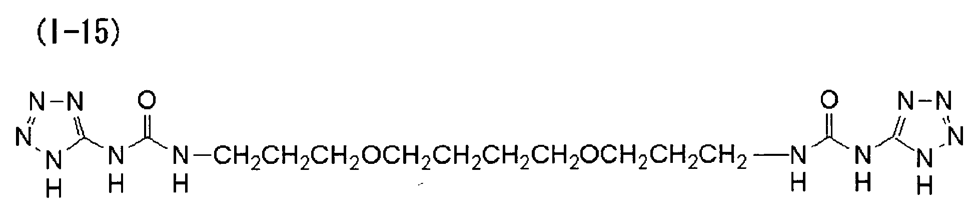

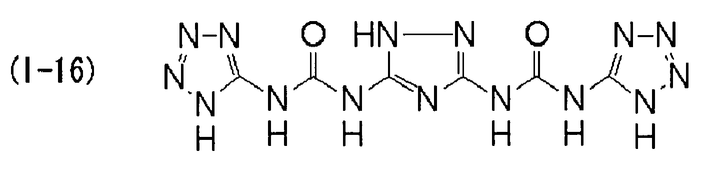

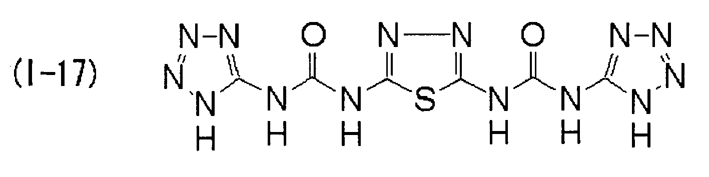

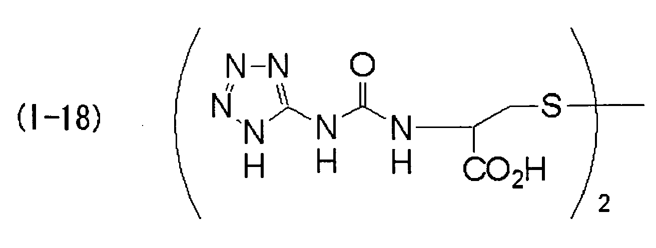

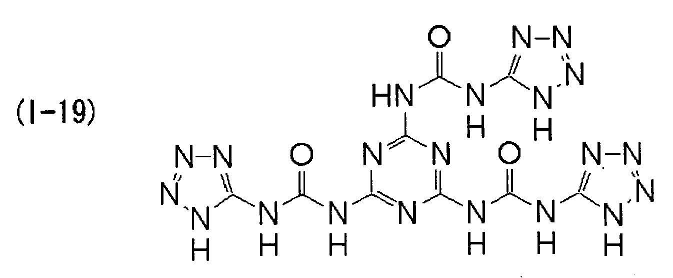

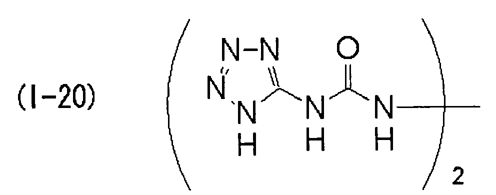

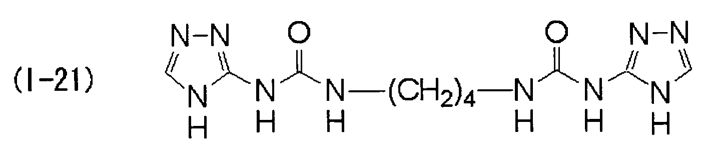

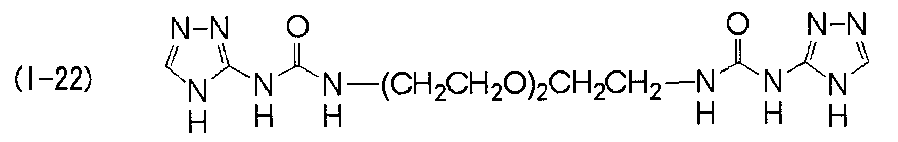

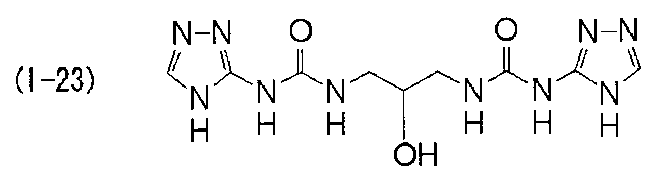

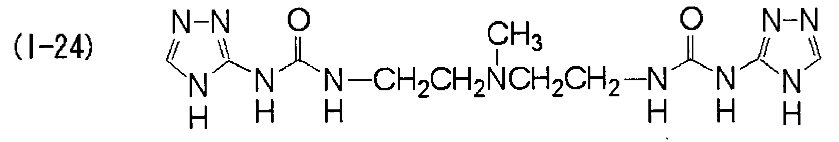

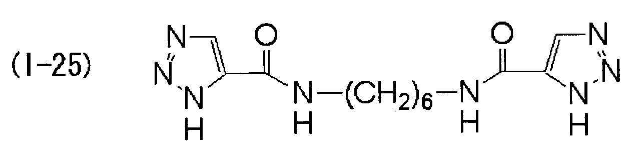

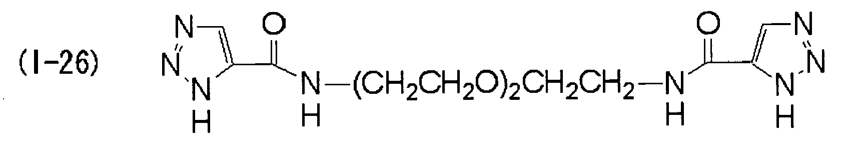

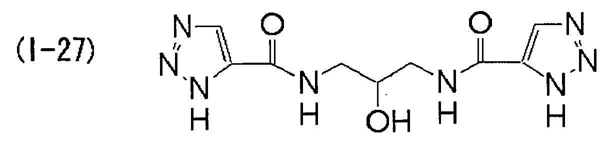

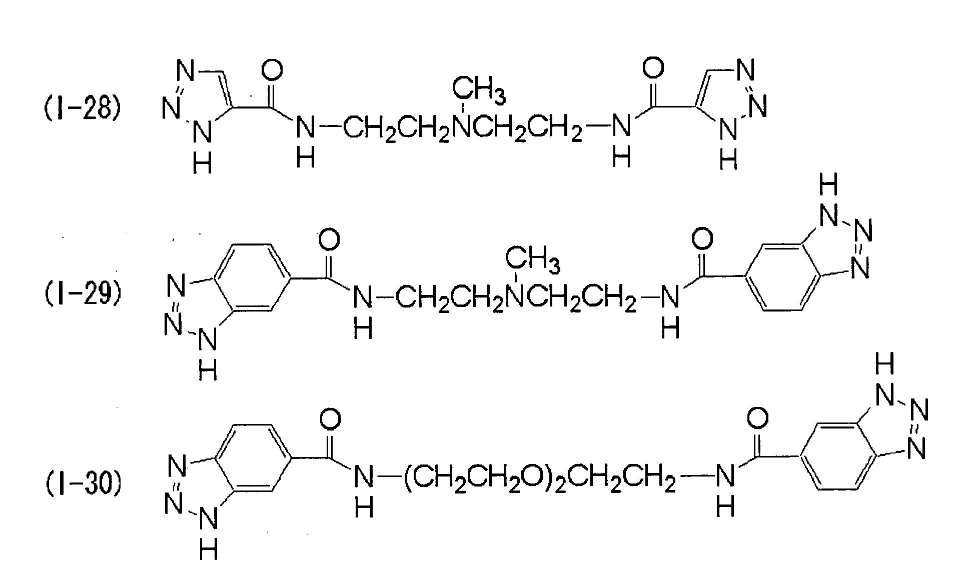

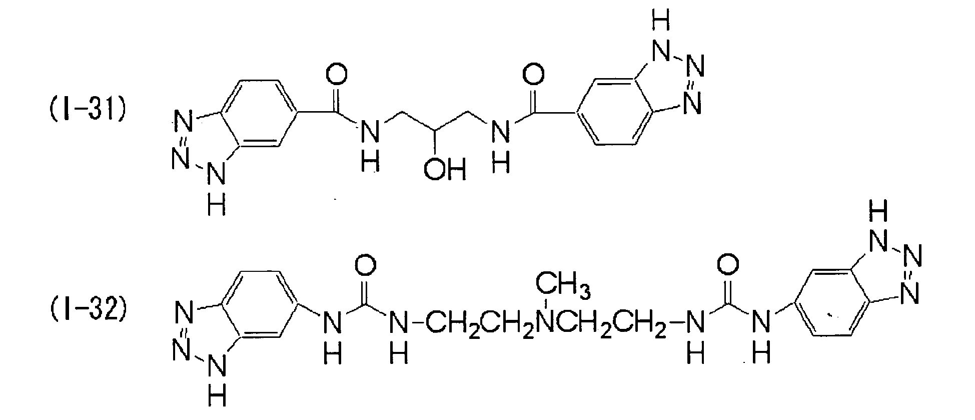

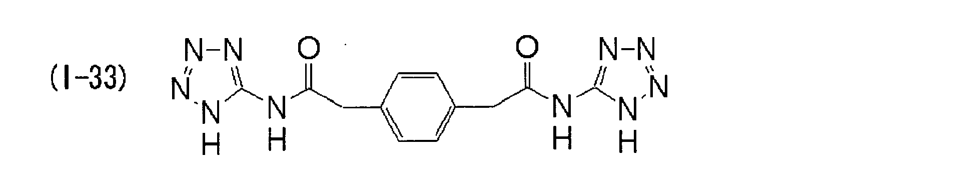

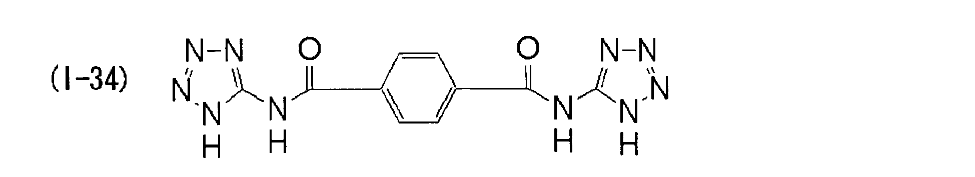

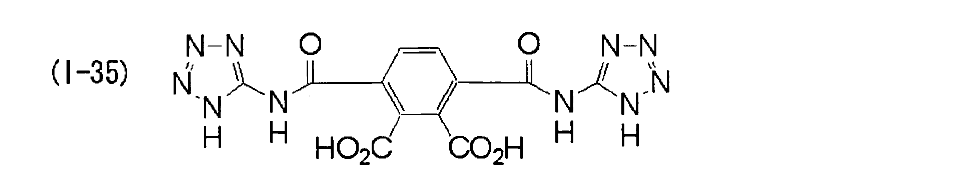

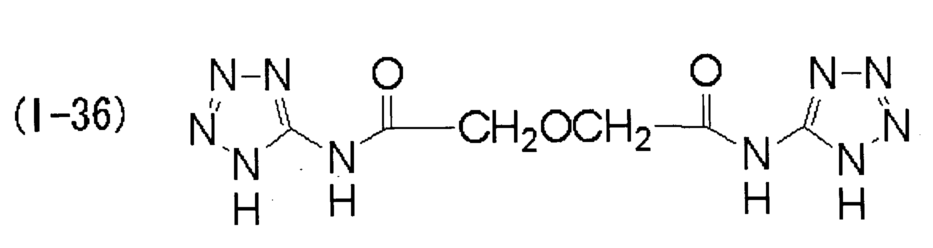

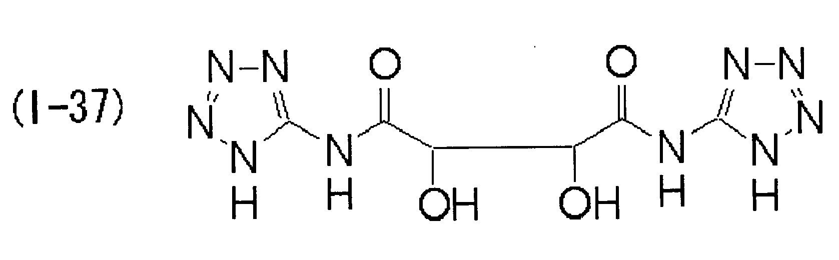

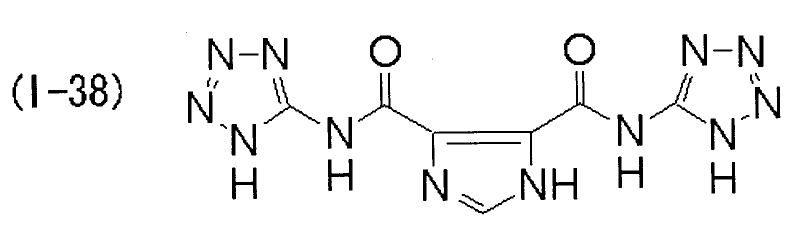

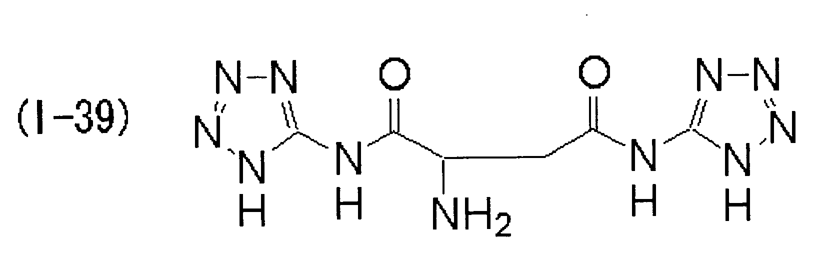

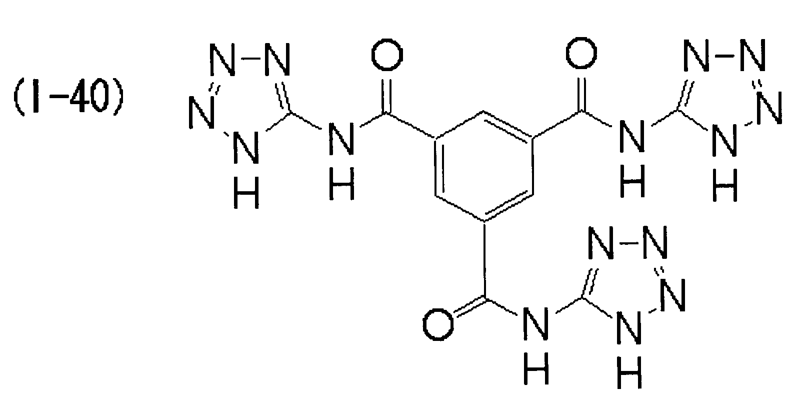

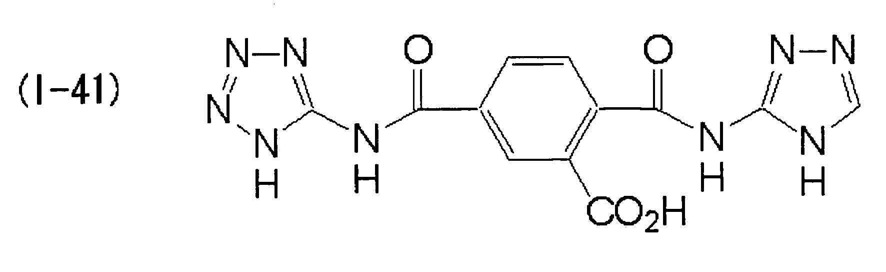

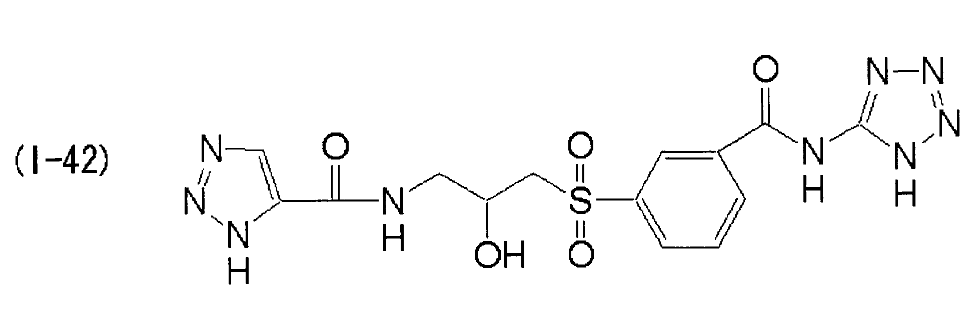

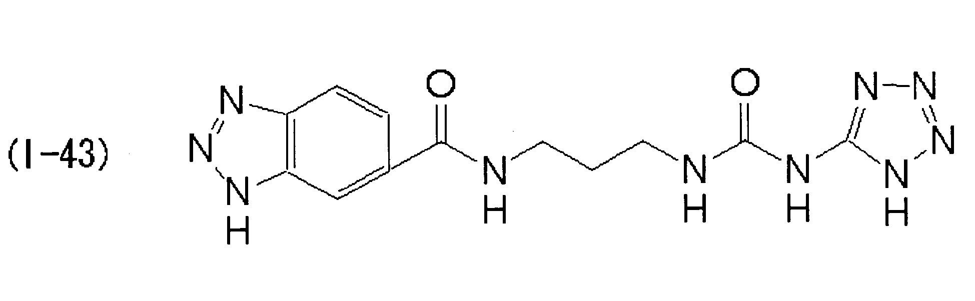

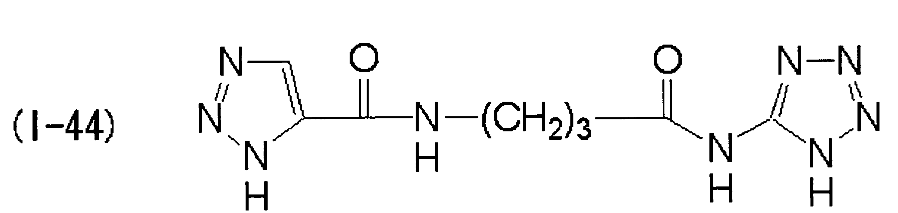

Among these exemplary compounds, Compounds (I-7), (I-11), (I-12), (I-23) and (I-33) are preferable from the viewpoint of synthesis suitability.

The compounds represented by the formula (I) may be contained singly or as a mixture of two or more thereof in the cleaning solution of the invention.

The total amount of the compounds of the formula (I) used in the invention is preferably in the range of 1×10⁻⁸ to 1×10⁻¹ mol, more preferably 1×10⁻⁷ to 1×10⁻² mol, further more preferably 1×10⁻⁶ to 1×10⁻³ mol, per L of a polishing liquid for metal used in polishing.

The cleaning agent of the invention is the form of an aqueous solution. That is, the cleaning agent, which needs to contain the compound represented by the formula (I) and contains other components used in combination as necessary, is dissolved preferably in an aqueous solvent. Water used as a solvent is preferably free of impurities from the viewpoint of its effect, or deionized water or superpurified water extremely lowered in the content of impurities is used. From the same point of view, electrolytic ion water obtained by electrolysis of water, or hydrogen water having hydrogen gas dissolved in water may be also used.

The cleaning solution of the invention may contain a wide variety of known additives as components of the cleaning agent as long as the effect of the invention is not spoiled. Hereinafter, additives as optional components are described.

### <(B) Polycarboxylic acid>

The cleaning agent of the invention preferably contains a polycarboxylic acid from the viewpoint of removing metal impurities and metal complexes.

Any polycarboxylic acid may be used in the invention as long as it is a compound containing at least 2 carboxyl groups in its molecule or a salt thereof.

The polycarboxylic acid usable in the invention includes, for example, a dicarboxylic acid such as oxalic acid, malonic acid or succinic acid, an oxypolycarboxylic acid such as tartaric acid, malic acid or citric acid, and salts thereof.

Among the polycarboxylic acids, citric acid, malonic acid and oxalic acid are preferable from the viewpoint of material safety, cost and detergency, and citric acid and oxalic acid are more preferable.

The polycarboxylic acids may be used singly, or in combination of two or more thereof in an optional ratio, in the cleaning agent of the invention.

The content of the polycarboxylic acid in the cleaning agent of the invention is preferably in the range of form 0.005 to 30% by mass, more preferably 0.01 to 10% by mass, based on the total mass of the cleaning agent, from the viewpoint of satisfying both cleaning efficiency and reduction in its influence on copper wiring.

The cleaning agent may contain other organic acids other than the polycarboxylic acid. The other organic acids are those organic compounds that are other than the polycarboxylic acid and exhibit acidity (pH < 7) in water. Examples thereof include organic compounds having an acidic functional group such as a carboxyl group, a sulfo group, a phenolic hydroxy group or a mercapto group.

When the other organic acids are used, the amount is preferably equal to, or less than, the amount of the polycarboxylic acid.

### <Surfactant>

The cleaning agent of the invention may contain a surfactant such as an anionic surfactant.

As the anionic surfactant usable in the invention, a general anionic surfactant may be suitably selected and used, and particularly an anionic surfactant having an aromatic ring structure in its molecule is preferable from the viewpoint of its ability to remove fine particles.

Examples of general-purpose anionic surfactants usable in the invention include a carboxylate, a sulfonate, a sulfuric ester salt and a phosphoric ester salt. Examples of the carboxylate include soap, N-acylamino acid salt, polyoxyethylene or polyoxypropylene alkyl ether carboxylate and acylated peptide; examples of the sulfonate include alkyl sulfonate, sulfosuccinate, α-olefin sulfonate and N-acyl sulfonate; examples of the sulfuric ester salt include sulfated oil, alkyl sulfate, alkyl ether sulfate, polyoxyethylene or polyoxypropylene alkyl allyl ether sulfate and alkylamide sulfate; examples of the phosphoric ester salt include alkyl phosphate and polyoxyethylene or polyoxypropylene alkyl allyl ether phosphate.

The anionic surfactant in the invention is preferably a surfactant having at least one aromatic ring structure in its molecule, and the aromatic ring includes a benzene ring, a naphthalene ring, an anthracene ring, a tetracene ring, a phenanthrene ring, a chrysene ring and a pyrene ring.

Examples of anionic surfactants that may be used preferably in the invention include alkyl benzene sulfonic acids and salts thereof, alkyl naphthalene sulfonic acids and salts thereof, alkyl diphenyl ether sulfonic acids and salts thereof, alkyl diphenyl ether disulfonic acids and salts thereof, phenolsulfonic acid/formalin condensates and salts thereof, and aryl phenolsulfonic acid/formalin condensates and salts thereof.

When these anionic surfactants have a salt structure, the salt structure is for example a sodium salt, a potassium salt, an ammonium salt, a triethanolamine salt or a tetramethyl ammonium salt.

Specific examples of the anionic surfactants include, for example, dodecyl benzene sulfonic acid, dodecyl diphenyl ether disulfonic acid, diphenyl ether disulfonic acid, propyl naphthalene sulfonic acid, propyl naphthalene sulfonic acid, triisopropyl naphthalene sulfonic acid, ammonium dodecyl benzene sulfonate, and ammonium dodecyl diphenyl ether sulfonate.

Other examples of the anionic surfactant that may be used in the invention include surfactants having a substituent such as a polyoxyethylene group, a polyoxypropylene group, a fluoroalkyl group, an acetylene group or a hydroxyl group, in addition to the aromatic ring structure in its molecule, and specific examples thereof include polyoxyethylene tristyryl phenyl ether phosphate, phenolsulfonic acid/formalin condensates.

Among the anionic surfactants described above, dodecyl benzene sulfonic acid, dodecyl diphenyl ether disulfonic acid and polyoxyethylene tristyryl phenyl ether phosphate are more preferable.

The anionic surfactant may be a commercial product, and preferable examples of the commercial product include Pelex NBL (trade name, sodium alkyl naphthalene sulfonate, manufactured by Kao Corporation), Neopelex GS (trade name, dodecylbenzenesulfonic acid, manufactured by Kao Corporation), Neopelex GS-15 (trade name, sodium dodecylbenzenesulfonate, manufactured by Kao Corporation), Pelex SS-L (trade name, sodium alkyl diphenyl ether sulfonate, manufactured by Kao Corporation), and Demol NL (trade name, sodium salt of β-naphthalene sulfonic acid/formalin condensate, manufactured by Kao Corporation).

These anionic surfactants may be used singly, or in combination of two or more thereof in an optional ratio, in the cleaning agent of the invention.

Surfactants other than the anionic surfactants that may be used in the invention include cationic surfactants, nonionic surfactants and amphoteric surfactants, and are particularly preferably those selected from the group consisting of the following nonionic surfactants.

Examples of the nonionic surfactant include an ether type, an ether ester type, an ester type and a nitrogen-containing type. Examples of the ether type include a polyoxyethylene alkyl or alkyl phenyl ether, an alkyl allyl formaldehyde-condensed polyoxyethylene ether, a polyoxyethylene polyoxypropylene block polymer and a polyoxyethylene polyoxypropylene alkyl ether; examples of the ether ester type include a polyoxyethylene ether of glycerin ester, a polyoxyethylene ether of sorbitan ester and a polyoxyethylene ether of sorbitol ester; examples of the ester type include a polyethylene glycol fatty acid ester, a glycerin ester, a polyglycerin ester, a sorbitan ester, a propylene glycol ester and a sucrose ester; and examples of the nitrogen-containing type include a fatty acid alkanolamide, a polyoxyethylene fatty acid amide and a polyoxyethylene alkylamide.

Other examples include fluorine-based surfactants and silicone-based surfactants.

When several kinds of surfactants are to be contained, two or more kinds of anionic surfactants may be used, or an anionic surfactant and a nonionic surfactant may be simultaneously used in combination.

The total content of the surfactants in the cleaning agent of the invention is preferably 0.01 to 10 g, more preferably 0.01 to 1 g, still more preferably 0.02 to 0.5 g, per L of the cleaning agent.

### (Chelating agent)

The cleaning agent of the invention may contain a chelating agent if necessary for reducing an adverse effect caused by mixing of polyvalent metal ions. As the chelating agent, a generally demineralizing agent for hard water may be used for a precipitation preventing agent of calcium and magnesium or a related compound thereof. The agent may be used alone or in combination of plural kinds of the components as needed. The amount of the chelating agent added is not restricted as long as the amount is sufficient for blocking metal ions such as mixed polyvalent metal ions, and is generally about 5 ppm to 10000 ppm in the cleaning agent.

### (pH)

The pH value of the cleaning agent of the invention is preferably 0.3 to 6.5, more preferably 5 or less. This because when the pH is 5 or less, easy adsorption of particles onto the surface of copper metal, which is considered causable in a neutral range by a zeta potential made opposite in sign between the surface of copper metal and the particles, may be prevented, thus preventing corrosion of the surface of copper metal.

From the viewpoint of preventing corrosion of the surface to be cleaned (that is, the surface of a substrate for semiconductor device) and of sufficient removal of metal contamination, the pH of the cleaning agent is preferably in the range of 0.5 to 5.

The pH value may be controlled by adding an organic acid to the cleaning agent.

For control of the pH of the cleaning agent, a general pH control agent, for example an inorganic acid such as nitric acid or sulfuric acid may be used as an acid, or potassium hydroxide or ammonium may be used as an alkali, but in consideration of the influence on copper wiring or the surface of a substrate, the general pH control agent mentioned above is not used, and it is preferable that the pH is controlled with an organic acid or an organic alkali, specifically oxalic acid or tetramethyl ammonium hydroxide.

The cleaning agent of the invention is used preferably for cleaning a semiconductor device substrate having, on the surface thereof, a metal or a metal compound layer or wiring formed therefrom. In the cleaning agent of the invention, there is no need to worry about corrosion or oxidation of copper wiring, and therefore, it may be used particularly preferably in cleaning a semiconductor device substrate having copper wiring on the surface thereof.

Hereinafter, a method of cleaning a semiconductor device by using the cleaning agent of the invention will be described.

### <Cleaning method>

The cleaning method using the cleaning agent of the invention is carried out subsequent to a chemical mechanical polishing process (CMP process) in the production of a semiconductor device.

Usually, the CMP process is a polishing process of supplying a polishing liquid to a polishing pad placed on a polishing platen; bringing the polishing pad into contact with a surface to be polished of an object to be polished such as a substrate for semiconductor device use, and relatively moving the surface to be polished and the polishing pad. In the subsequent cleaning process, generally, the polished substrate for semiconductor device use is put on a spinner, and the cleaning agent is supplied onto the surface to be polished and onto the back side of the substrate at flow rate of 100 to 2000 ml/min, and the substrate is brush-scrubbed for 10 to 60 seconds at room temperature.

A commercial cleaning machine, for example, a wafer cleaning machine (trade name: ZAB8W2M, manufactured by MAT) may be used, and scrub cleaning may be carried out with contact of a PVA roll brush used in the scrub section of the cleaning machine.

Examples of the metal used in the substrate for semiconductor device use to be polished are metals mainly of W or Cu. Recently, it has become possible to develop LSIs using copper of low wiring resistance.

With the recent trend to finer widths of wiring for increasing the density, it is required to enhance the conductivity of copper wiring and resistance to electron migration, and for such materials of high precision, technology for high productivity processing that does not cause contamination in high-precision and high-purity materials is required.

In the processes for cleaning a substrate having Cu formed on the surface, or a substrate having an insulation film of low dielectric constant as an interlayer dielectric and having a copper wiring formed on the surface thereof, in particular in cleaning processes that are conducted after CMP (chemical mechanical polishing) process of a Cu film, or cleaning processes that are conducted after opening holes in the interlayer dielectric on the wiring by dry etching, in these cleaning processes it is particularly important to have efficient removal of impurity metals and particles left over on the surface for the sake of purity and precision of wiring, and the cleaning agent of the invention is preferably used in these cleaning processes from such point of view. As described previously, the cleaning agent of the invention does not generate corrosion or oxidation in copper wiring, and from this viewpoint, the cleaning agent of the invention is preferably used.

To confirm the effectiveness of impurity removal in the cleaning process, foreign matter on a wafer must be detected. In the invention, a light scatter type foreign matter measuring instrument (for example, trade name: SP1TBI; manufactured by KLA Tencor) is preferably used as a foreign matter detecting device. In this system, to detect foreign matter on the wafer, a laser beam is emitted to the wafer surface, and instead of detecting the normal reflected light of the laser beam, the light intensity of the scattered laser beam is measured by a photo detector disposed in a predetermined direction, thereby detecting foreign matter on the wafer. The laser beam sequentially scans the wafer surface, but if an uneven portion such as foreign matter exists on the wafer surface, a change in the scattering intensity occurs. In this system, the light scattering intensity is compared with light scattering intensities preliminarily calibrated using standard particles, and the light scattering intensity is converted into a standard particle, and the size and position of foreign matter may be displayed.

According to the cleaning method using the cleaning agent of the invention, impurity metals on the surface of a substrate for semiconductor device use after planarizing process by CMP, impurity organic or inorganic materials including polishing wastes from a substrate material and an interlayer dielectric, and particles such as abrasive grains can be removed efficiently. The cleaning method using the cleaning agent of the invention is particularly suitable for devices which require efficient removal of impurities in each process, in particular when planarizing for a device demanding high precision of wiring, or for a multilayered wiring board forming a new interlayer dielectric and then wiring after planarizing of single-layer substrate. When a substrate for semiconductor device has copper wiring, the copper wiring is not corroded or oxidized in the cleaning method.

### EXAMPLES

Examples of the present invention are described below. However, the invention is not limited to these examples.

### <Preparation of polishing liquid>

• Colloidal silica (abrasives: average particle size 30 nm) 5 g/L
• Benzotriazole (BTA) 1 g/L
• Glycine (organic acid) 10 g/L
• Purified water (used to adjust the total volume to 1000 mL)

Purified water was added to adjust the total volume to 1000 mL, and the pH was adjusted to 4.5 by using nitric acid and ammonia.

Just before polishing 15 g/L of 30% hydrogen peroxide (oxidizing agent) was added to the polishing liquid.

### <Polishing of Cu wafer>

### (1) Evaluation of Polishing Rate

### Polishing of an 8-inch wafer

The polishing device used was LGP-612 (trade name, manufactured by Lap Master) while a slurry was supplied, a film on each wafer was polished under the following conditions.

Substrate: silicon wafer with 8-inch copper film

Table rotation speed: 64 rpm

Head rotation speed: 65 rpm
(processing linear velocity = 1.0 m/s)

Polishing pressure: 140 hPa

Polishing pad: trade name IC-1400 (K-grv)+(A21) manufactured by Rohm and Haas Slurry supply speed: 200 ml/min

### [Examples 1 to 14 and Comparative Examples 1 to 8]

### <Preparation of Cleaning Agent>

• (A) Compound represented by the formula (I) or Comparative Compound (Compound shown in Table 1 or 2) (Amount shown in Table 1 or 2)
• (B) Organic acid (polycarboxylic acid), organic alkali (Compound shown in Table 1 or 2) (Amount shown in Table 1 or 2)
Purified water was added to adjust the total volume to 1000 mL.

In Tables 1 and 2, BTA is benzotriazole, tetrazole is 1H-tetrazole, TMAH is tetramethyl ammonium hydroxide, and TEAH is tetraethyl ammonium hydroxide.

### <Cleaning Test>

In the cleaning test, the silicon substrates with a copper film that had been polished with the polishing liquid under the above specified condition were cleaned with the cleaning agents prepared according to the formulations in Examples 1 to 14 and Comparative Examples 1 to 8.

The substrate was cleaned by using contact scrub cleaning with a PVA roll brush in the scrub section of the wafer cleaning machine (trade name: ZAB8W2M, manufactured by MAT). Each cleaning agent was continuously supplied for 25 seconds at a flow rate of 400 ml/min at the upper side of the polished substrate and 400 ml/min at the lower side, and then purified water (deionized water) was supplied continuously for 35 seconds at a flow rate of 650 ml/min at the upper side of the polished substrate 1 and 500 ml/min at the lower side, and the substrate was finally dried for 30 seconds by the spin drying device in the cleaning machine.

### <Evaluation of Ability to Remove Residues of Organic Matters>

SEMATECH pattern wafers were used in place of the silicon wafers with a copper film and subjected to polishing, cleaning and drying under the same conditions as described above. Thereafter, the state of the wafer surface was observed with a sectional scanning electron microscope (SEM) S-4800 (trade name, manufactured by Hitachi High-Technologies Corp.) (magnification: × 50000) to confirm the state of removal of residues of organic matters under the following criteria. A to B are in a practically acceptable range.
A: No residues of organic matters are recognized on the surface of the substrate.
B: Local residues of organic matters in such small amounts as to have no effect on the surface of the substrate are recognized.
C: Residues of organic matters are recognized on the whole surface of the substrate.
D: Significantly large amounts of residues of organic matters are recognized on the whole surface of the substrate.

### <Evaluation of Corrosiveness>

The silicon wafer with a copper film were subjected to polishing, cleaning and drying under the same conditions as described above. For evaluating the state of corrosion of copper wiring and the state, attributable to the corrosion, of surface roughening of copper wiring on the substrate, the surface roughness (Sa) of the copper wiring on the substrate was measured by observation under an atomic force microscope (AFM) (trade name: Nano-R (trademark), manufactured by Pacific Nano Technology) and evaluated under criteria that follow. That is, when a sample has less surface roughness on the copper wiring, its copper corrosion is judged to be suppressed. As the Sa value, a numerical value calculated with the AFM instrument is used.
a: The surface roughness (Sa) is less than 0.6 nm.
b: The surface roughness (Sa) is 0.6 nm to less than 1.0 nm.
c: The surface roughness (Sa) is 1.0 nm to 10.0 nm.
d: The surface roughness (Sa) is more than 10.0 nm.

The test results are shown in Tables 1 and 2 below.

**Table 1**

| | Organic acid/alkali | | Compound represented by formula (I) or Comparative Compound | | pH | Removal of residues of organic matters | Corrosion |
|---|---|---|---|---|---|---|---|
| | Compound | Content (g/L) | Compound | Content (g/L) | | | |
| Example 1 | citric acid | 0.50 | (1-7) | 0.10 | 3.1 | B | a |
| Example 2 | citric acid | 0.50 | (I-11) | 0.10 | 3.1 | B | a |
| Example 3 | malonic acid | 0.50 | (I-11) | 0.10 | 2.4 | B | a |
| Example 4 | malonic acid | 0.50 | (I-12) | 0.10 | 2.4 | B | a |
| Example 5 | citric acid | 0.50 | (1-32) | 0.10 | 3.1 | B | a |
| Example 6 | citric acid | 0.50 | (1-23) | 0.01 | 3.1 | A | a |
| Example 7 | malonic acid | 0.50 | (I-23) | 0.50 | 2.4 | A | a |
| Example 8 | malonic acid | 0.50 | (I-32) | 0.10 | 2.4 | B | a |
| Example 9 | citric acid | 0.50 | (1-23) | 0.50 | 3.1 | A | a |
| Example 10 | oxalic acid | 0.50 | (1-11) | 0.50 | 2.4 | B | b |
| Example 11 | oxalic acid | 0.50 | (1-23) | 0.10 | 2.4 | A | a |
| Example 12 | oxalic acid | 0.50 | (1-32) | 0.50 | 2.4 | A | a |
| Example 13 | citric acid/TMA H | 0.5/0.5 | (1-11) | 0.50 | 5.6 | B | b |
| Example 14 | citric acid/TMA H | 0.5/0.5 | (1-23) | 0.10 | 11.4 | A | b |

**Table 2**

| | Organic acid/alkali | | Compound represented by formula (I) or Comparative Compound | | pH | Removal of residues of organic matters | Corrosion |
|---|---|---|---|---|---|---|---|
| | Compound | Content (g/L) | Compound | Content (g/L) | | | |
| Comparative Example 1 | citric acid | 0.24 | BTA | 0.00 | 3.1 | D | b |
| Comparative Example 2 | citric acid | 2.00 | tetrazole | 0.00 | 3.1 | D | c |
| Comparative Example 3 | malonic acid | 0.29 | BTA | 0.00 | 2.4 | D | b |
| Comparative Example 4 | oxalic acid | 0.50 | BTA | 0.00 | 2.4 | D | c |
| Comparative Example 5 | TMAH | 0.43 | - | 2.00 | 9.5 | B | d |
| Comparative Example 6 | TMAH | 0.43 | BTA | 0.05 | 11.5 | D | c |
| Comparative Example 7 | TMAH | 0.57 | BTA | 0.50 | 11.5 | D | b |
| Comparative Example 8 | TEAH | 0.57 | BTA | 0.05 | 11.3 | D | d |

It may be seen from the results in Tables 1 and 2 that when the cleaning agents of the invention are used in cleaning after the CMP process, residues of organic matters adhering to the surface may be effectively cleaned and removed without generating corrosion of copper wiring.

On the other hand, Comparative Examples 1 to 4 wherein a heterocyclic compound and a polycarboxylic acid are contained without using the compound represented by the formula (I) in the invention and Comparative Examples 6 to 8 having high pH using a heterocyclic compound and an organic alkali are inferior in an ability to remove residues of organic matters, and Comparative Example 5 using only an organic alkali without using the compound represented by the formula (I) has undergone significant corrosion of copper wiring.
Some embodiments of the present invention will be shown hereafter.
<1> A cleaning agent for cleaning a semiconductor device having copper wiring on the surface thereof after a chemical mechanical polishing process in a production process of the semiconductor device, the cleaning agent comprising a compound represented by the following formula (I):

   X¹-L-X² formula (I)

   wherein, in formula (I), X¹ and X² each independently represent a monovalent substituent formed by removing one hydrogen atom from a heterocycle containing at least one nitrogen atom, and L represents a divalent linking group.
<2> The cleaning agent of the above-mentioned <1>, wherein the divalent linking group represented by L in the formula (I) comprises a group selected from an ureido group, a thioureido group, an amide group, an ester group, a carbonate group, a carbamate group, a sulfonamide group, a sulfonureido group, a hydroxy group, an ether group, a thioether group, an amino group, a carboxy group, a sulfo group and a heterocyclic group.
<3> The cleaning agent of the above-mentioned <1> or <2>, wherein a heterocycle in the monovalent substituent represented by X¹ and X² in the formula (I) is tetrazole, 1,2,4-triazole, 1,2,3-triazole, or benzotriazole.
<4> The cleaning agent of the above-mentioned <1>, wherein the additive amount of the compound of the formula (I) is in the range of from 1×10⁻⁶ to 1×10⁻³ mol per L of a polishing liquid for metal used in polishing.
<5> The cleaning agent of the above-mentioned <1>, which further includes at least one polycarboxylic acid selected from the group consisting of citric acid, malonic acid and oxalic acid.
<6> The cleaning agent of the above-mentioned <1>, wherein the content of the polycarboxylic acid is 0.01 to 10% by mass with respect to the total mass of the cleaning agent.
<7> The cleaning agent of the above-mentioned <1>, wherein the pH of the cleaning agent is 0.3 to 5.0.
<8> A method of cleaning a semiconductor device provided with copper wiring thereon, which comprises using the cleaning agent of the above-mentioned <1>.

The cleaning agent of the invention is used preferably for a semiconductor device provided thereon with copper wiring and may effectively remove particles on the surface of the device without adversely affecting fine copper wiring used widely in recent years.

## Claims

1. A cleaning agent for cleaning a semiconductor device having copper wiring on the surface thereof after a chemical mechanical polishing process in a production process of the semiconductor device, the cleaning agent comprising a compound represented by the following formula (I):
X¹-L-X² formula (I)
wherein, in formula (I), X¹ and X² each independently represent a monovalent substituent formed by removing one hydrogen atom from a heterocycle containing at least one nitrogen atom, and L represents a divalent linking group.

2. The cleaning agent of claim 1, wherein the divalent linking group represented by L in the formula (I) comprises a group selected from an ureido group, a thioureido group, an amide group, an ester group, a carbonate group, a carbamate group, a sulfonamide group, a sulfonureido group, a hydroxy group, an ether group, a thioether group, an amino group, a carboxy group, a sulfo group and a heterocyclic group.

3. The cleaning agent of claim 1, wherein a heterocycle in the monovalent substituent represented by X¹ and X² in the formula (I) is tetrazole, 1,2,4-triazole, 1,2,3-triazole, or benzotriazole.

4. The cleaning agent of claim 1, wherein the amount of the compound of the formula (I) is in the range of from 1×10⁻⁶ to 1×10⁻³ mol per L of a polishing liquid for metal used in polishing.

5. The cleaning agent of claim 1, which further comprises at least one polycarboxylic acid selected from the group consisting of citric acid, malonic acid and oxalic acid.

6. The cleaning agent of claim 1, wherein the content of the polycarboxylic acid is 0.01 to 10% by mass with respect to the total mass of the cleaning agent.

7. The cleaning agent of claim 1, wherein the pH of the cleaning agent is 0.3 to 5.0.

8. A method of cleaning a semiconductor device provided with copper wiring thereon, which comprises using the cleaning agent of claim 1.
